# FASCICULE DE BREVET EUROPEEN

(11) **EP 3 607 582 B1**
(45) Date de publication et mention de la délivrance du brevet: **20.10.2021**
(21) Numéro de dépôt: 18718892.5
(22) Date de dépôt: 04.04.2018
(51) Int. Cl.: H01L 25/075, H01L 25/16, G09G 3/32

(54) **DISPOSITIF D'AFFICHAGE D'IMAGES EMISSIF A LED**
LED-BILDANZEIGEVORRICHTUNG
LED IMAGE DISPLAY DEVICE

(30) Priorité: 05.04.2017 FR 1752955
(43) Date de publication de la demande: 12.02.2020
(73) Titulaire: Commissariat à l'Energie Atomique et aux Energies Alternatives, 75015 Paris (FR)
(72) Inventeur: ROSSINI, Umberto, 38500 Coublevie (FR)
(74) Mandataire: Cabinet Beaumont
(86) Numéro de dépôt international: PCT/FR2018/050844
(87) Numéro de publication internationale: WO 2018/185434

(56) Documents cités:
- DE-A1- 19 950 839
- US-A1- 2005 128 767
- US-A1- 2005 128 767
- US-A1- 2012 080 692
- US-A1- 2012 080 692
- US-A1- 2016 258 588
- US-A1- 2016 258 588
- US-A1- 2017 061 867
- US-A1- 2017 061 867
- CHRISTOPHER A BOWER ET AL: "Transfer-Printed Microscale Integrated Circuits for High Performance Display Backplanes", IEEE TRANSACTIONS ON COMPONENTS, PACKAGING AND MANUFACTURING TECHNOLOGY, IEEE, USA, vol. 1, no. 12, 1 December 2011 (2011-12-01), pages 1916-1922, XP011391217, ISSN: 2156-3950, DOI: 10.1109/TCPMT.2011.2128324
- Christopher A. Bower ET AL: "Emissive displays with transfer-printed assemblies of 8??[mu]m???15??[mu]m inorganic light-emitting diodes", Photonics Research, vol. 5, no. 2, 1 April 2017 (2017-04-01), page A23, XP055407047, ISSN: 2327-9125, DOI: 10.1364/PRJ.5.000A23

## Description

La présente demande de brevet revendique la priorité de la demande de brevet français FR17/52955.

### Domaine

La présente demande concerne la réalisation d'un dispositif d'affichage d'images émissif à diodes électroluminescentes (LED), par exemple un écran de télévision, d'ordinateur, de smartphone, de tablette numérique, etc.

### Exposé de l'art antérieur

Il a déjà été proposé, dans la demande de brevet français n°1561421 déposée le 26 novembre 2015, un dispositif d'affichage d'images comportant une pluralité de puces électroniques élémentaires disposées en matrice sur un même substrat de report. Les puces sont montées solidaires du substrat de report et connectées à des éléments de connexion électrique du substrat de report pour leur commande. Chaque puce comporte un empilement d'une LED et d'un circuit de commande de la LED et correspond à un pixel du dispositif. Le document US 2012/080692 A1 divulgue un dispositif d'affichage d'images avec un substrat de report avec des connexions électriques et des LEDs.

Il serait souhaitable de pouvoir améliorer au moins en partie certains aspects d'un dispositif d'affichage d'images de ce type.

### Résumé

Ainsi, un mode de réalisation prévoit un dispositif d'affichage émissif comportant :
un substrat de report comportant des éléments de connexion électrique ; et
une pluralité de puces semiconductrices solidarisées au substrat et connectées aux éléments de connexion électrique du substrat pour leur commande, chaque puce comportant :
   - au moins une LED ;
   - une pluralité de bornes de connexion au substrat ; et
   - un circuit de commande à base de transistors adapté à appliquer à la dite au moins une LED un signal de polarisation en fonction de signaux reçus sur les bornes de connexions de la puce au substrat,
dans lequel le substrat de report comprend une plaque isolante, les éléments de connexion électrique du substrat étant formés par impression, sur une face de ladite plaque, d'un premier niveau conducteur, suivi d'un niveau isolant, suivi d'un deuxième niveau conducteur, les éléments de connexion électrique du substrat comportant :
   une pluralité de premières pistes conductrices formées dans le premier niveau conducteur ;
   une pluralité de deuxièmes pistes conductrices formées dans le deuxième niveau conducteur ; et
   pour chaque puce du dispositif, une pluralité de plages de connexion électrique connectées respectivement aux bornes de connexion de la puce, lesdites plages étant toutes formées dans le deuxième niveau conducteur.

Selon un mode de réalisation, les premières pistes conductrices sont sensiblement parallèles, et les deuxièmes pistes conductrices sont sensiblement orthogonales aux premières pistes.

Selon un mode de réalisation, dans chaque puce élémentaire du dispositif, ladite au moins une LED de la puce est formée dans un premier substrat à base de semiconducteur III-V, et le circuit de commande de la puce est formé dans un deuxième substrat à base de silicium, accolé et connecté électriquement au premier substrat.

Selon un mode de réalisation, dans chaque puce élémentaire, les bornes de connexion de la puce sont formées du côté de la face du deuxième substrat opposée au premier substrat.

Selon un mode de réalisation, chaque puce élémentaire est disposée de façon que la face de son deuxième substrat opposée au premier substrat soit tournée vers le substrat de report de façon à réaliser des connexions électriques directes entre les bornes de connexion de la puce et les plages de connexion électrique du substrat de report.

Selon un mode de réalisation, pour chaque puce du dispositif, le substrat de report comprend au moins une plage de connexion électrique connectée à une première piste conductrice du substrat de report, et au moins une plage de connexion électrique connectée à une deuxième piste conductrice du substrat de report.

Selon un mode de réalisation, chaque puce élémentaire comprend une première borne de connexion au substrat destinée à recevoir un signal de réglage de ladite au moins une LED de la puce.

Selon un mode de réalisation, chaque puce élémentaire comprend en outre une deuxième borne de connexion au substrat destinée à recevoir un signal de sélection et/ou de synchronisation.

Selon un mode de réalisation, chaque puce élémentaire comprend en outre des troisième et quatrième bornes de connexion au substrat destinées à recevoir respectivement un potentiel d'alimentation haut et un potentiel d'alimentation bas de la puce.

Selon un mode de réalisation, chaque puce élémentaire comprend une pluralité de LED, et la première borne de connexion de la puce est destinée à recevoir, pour chaque LED de la puce, un signal de réglage individuel de la LED, les signaux de réglage individuels des différentes LED de la puce étant multiplexés temporellement sur ladite première borne.

Selon un mode de réalisation, dans chaque puce élémentaire, le circuit de commande de la puce est adapté à démultiplexer les signaux reçus sur ladite première borne et à appliquer à chaque LED de la puce un signal de polarisation fonction du signal de réglage individuel de la LED reçu sur ladite première borne.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est un schéma électrique des circuits d'une puce élémentaire d'un exemple d'un dispositif d'affichage d'images ;
la figure 2 est un schéma électrique des circuits d'une puce élémentaire d'un autre exemple d'un dispositif d'affichage d'images ;
la figure 3 est un schéma électrique simplifié des circuits d'une puce élémentaire d'un exemple d'un dispositif d'affichage d'images selon un mode de réalisation ;
la figure 4 est un chronogramme illustrant un exemple d'un mode de fonctionnement de la puce élémentaire de la figure 3 ;
la figure 5 est un schéma électrique simplifié des circuits d'une puce élémentaire d'un autre exemple d'un dispositif d'affichage d'images selon un mode de réalisation ;
la figure 6 est un schéma électrique simplifié des circuits d'une puce élémentaire d'un autre exemple d'un dispositif d'affichage d'images selon un mode de réalisation ;
les figures 7 et 8 sont des chronogrammes illustrant un exemple d'un mode de fonctionnement de la puce élémentaire de la figure 6 ;
les figures 9A, 9B et 9C sont des vues schématiques respectivement de dessus, en coupe et de dessous d'un exemple d'une puce élémentaire d'un dispositif d'affichage d'images selon un mode de réalisation ; et
la figure 10 est une vue de dessus d'un exemple d'un substrat de report d'un dispositif d'affichage d'images selon un mode de réalisation.

### Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés. En particulier, la fabrication des puces élémentaires des dispositifs d'affichage décrits n'a pas été détaillée, la fabrication de ces puces étant à la portée de l'homme du métier à partir des enseignements de la présente description. A titre d'exemple, les puces élémentaires des dispositifs d'affichage décrits, comportant chacune une ou plusieurs LED et un circuit de commande à base de transistors, peuvent être fabriquées selon des procédés identiques ou similaires à ceux décrits dans la demande de brevet français n°1561421 susmentionnée. Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence à l'orientation des figures, étant entendu que, dans la pratique, les dispositifs décrits peuvent être orientés différemment. Sauf précision contraire, les expressions "approximativement", "sensiblement", et "de l'ordre de" signifient à 10 % près, de préférence à 5 % près, ou, lorsqu'il s'agit de valeur angulaires ou d'orientation angulaires, à 10 degrés près, de préférence à 5 degrés près.

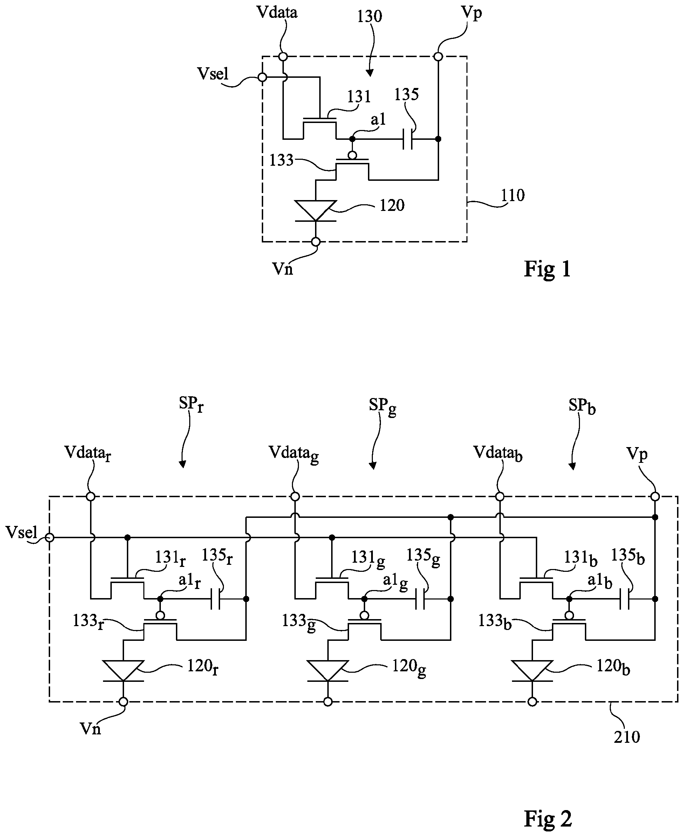

La figure 1 est un schéma électrique des circuits d'une puce élémentaire 110 d'un dispositif d'affichage d'images du type décrit dans la demande de brevet français n°1561421 susmentionnée.

La puce 110 comprend une LED 120, de préférence une LED inorganique, par exemple une LED au nitrure de gallium ou à base de tout autre semiconducteur III-V adapté à la réalisation d'une LED. La puce 110 comprend en outre un circuit actif 130 de commande de la LED 120, par exemple un circuit à base de transistors, adapté à contrôler l'émission de lumière par la LED.

A titre d'exemple, le circuit de commande 130 et la LED 120 sont d'abord formés séparément, respectivement dans et sur un substrat de silicium pour le circuit 130, et sur un substrat de croissance adapté, par exemple en saphir, pour la LED 120. La LED 120 est réalisée de façon à présenter des contacts électriques d'anode et de cathode du côté de sa face opposée au substrat de croissance. Le circuit de contrôle 130 comprend quant à lui, du côté d'une première face du substrat de silicium, des zones de connexion électrique destinées à être mises en contact avec les contacts d'anode et de cathode de la LED, et, du côté d'une deuxième face du substrat de silicium opposée à la première face, des bornes de connexion à un dispositif extérieur pour la commande de la puce. Le circuit 130 et la LED 120 sont ensuite solidarisés par collage de la face de la LED opposée au substrat de croissance sur la première face du circuit 130. La puce comprenant le circuit 130 et la LED 120 est ensuite reportée sur un substrat de report, par exemple un substrat de report passif, comportant des éléments de connexion électrique pour l'alimentation et la commande de la puce. Lors du report, la puce est disposée de façon que la deuxième face du circuit 130 de la puce soit tournée vers le substrat de report, afin de réaliser des connexions électriques directes entre les bornes de connexion à l'extérieur de la puce et des plages de connexion électrique du substrat de report. Le substrat de croissance peut en outre être retiré avant ou après la fixation de la puce sur le substrat de report.

Dans cet exemple, la puce 110 comprend quatre bornes de connexion à l'extérieur Vp, Vn, Vsel, et Vdata. Par souci de simplification, dans la présente description, les signaux électriques appliqués sur les bornes de connexion des puces sont désignés par les mêmes références que les bornes elles-mêmes. Les bornes Vp et Vn sont destinées à recevoir respectivement un potentiel d'alimentation bas Vp (par exemple la masse) et un potentiel d'alimentation haut (c'est-à-dire supérieur au potentiel d'alimentation bas) Vn de la puce. Les bornes Vsel et Vdata sont destinées à recevoir des signaux de commande de la puce. Plus particulièrement, le signal Vsel est un signal de sélection de la puce, et le signal Vdata est un signal de réglage du niveau de luminosité de la puce.

Dans l'exemple de la figure 1, le circuit de commande 130 de la puce comprend deux transistors 131 et 133 et un élément capacitif 135, par exemple un condensateur. Dans cet exemple, les transistors 131 et 133 sont des transistors MOS. Plus particulièrement, le transistor 131 est un transistor MOS à canal N et le transistor 133 est un transistor MOS à canal P. Le transistor 131 a un premier noeud de conduction (source ou drain dans cet exemple) connecté à la borne Vdata, un deuxième noeud de conduction (drain ou source dans cet exemple) connecté à un noeud intermédiaire a1 de la puce, et un noeud de commande (grille dans cet exemple) connecté à la borne Vsel. L'élément capacitif 135 a une première électrode connectée au noeud a1 et une deuxième électrode connectée à la borne Vp. Le transistor 133 a un premier noeud de conduction connecté à la borne Vp, un deuxième noeud de conduction connecté à l'anode de la LED 120, et un noeud de commande connecté au noeud a1. La cathode de la LED 120 est connectée à la borne Vn.

Dans la puce élémentaire 110, le transistor 131 est utilisé en commutation (passant ou bloqué) pour permettre ou non la mise à jour du réglage de luminosité de la LED. Le transistor 133 fonctionne en régime linéaire pour contrôler l'intensité du courant injecté dans la LED.

Le fonctionnement de la puce élémentaire 110 lors d'une phase de mise à jour du niveau de luminosité du pixel est le suivant. Le transistor 131 est fermé (rendu passant) par l'application d'un signal de commande adapté sur la borne Vsel. L'élément capacitif 135 se charge alors à un niveau de tension fonction du signal de réglage appliqué sur la borne Vdata de la puce. Le niveau du signal de réglage Vdata fixe le potentiel du noeud a1, et par conséquent l'intensité du courant injecté dans la LED par le transistor 133, et donc l'intensité lumineuse émise par la LED. Le transistor 131 peut ensuite être rouvert. Le noeud a1 reste alors à un potentiel sensiblement égal au potentiel Vdata. Ainsi, le courant injecté dans la LED reste sensiblement constant après la réouverture du transistor 131, et ce jusqu'à la prochaine mise à jour du potentiel du noeud a1.

En pratique, un dispositif d'affichage peut comporter une pluralité de puces élémentaires 110 identiques ou similaires montées sur un même substrat de report selon un agencement en matrice selon des lignes et des colonnes, les puces étant connectées à des éléments de connexion électrique du substrat pour leur commande, et chaque puce correspondant à un pixel du dispositif d'affichage.

A titre d'exemple, les pixels du dispositif d'affichage sont commandables simultanément ligne par ligne. Autrement dit, pour chaque ligne de la matrice, les puces de la ligne ont leurs bornes de commande Vsel connectées à une même piste conductrice de commande de ligne du substrat de report, les puces de lignes distinctes ayant leurs bornes de commande Vsel connectées à des pistes conductrices de commande de ligne distinctes du substrat de report. De plus, pour chaque colonne de la matrice, les puces de la colonne ont leurs bornes de commande Vdata connectées à une même piste conductrice de commande de colonne du substrat de report, les puces de colonnes distinctes ayant leurs bornes de commande Vdata connectées à des pistes conductrices de commande de colonne distinctes du substrat de report. Lors de l'affichage d'une image, les pixels du dispositif peuvent ainsi être rafraîchis simultanément ligne par ligne.

Pour réaliser un dispositif d'affichage d'images couleur, une possibilité est de prévoir, pour chaque pixel du dispositif, plusieurs puces élémentaires voisines adaptées à émettre dans des gammes de longueurs d'ondes distinctes, par exemple trois puces élémentaires adaptées à émettre respectivement de la lumière rouge, de la lumière verte et de la lumière bleue. Chaque puce élémentaire correspond alors à un sous-pixel du dispositif. Les puces élémentaires de couleurs distinctes peuvent comporter des LED de natures distinctes adaptées à émettre dans des gammes de longueurs d'ondes distinctes, ou des LED de même nature surmontées de filtres ou d'éléments de conversion photoluminescents de natures distinctes.

Un problème qui se pose réside alors dans le nombre et la densité des éléments de connexion électrique qui doivent être prévus sur le substrat de report pour permettre de commander individuellement chaque sous-pixel du dispositif.

Pour limiter le nombre d'éléments de connexion électrique du substrat de report, une possibilité est d'intégrer sur une même puce élémentaire les différents sous-pixels d'un même pixel du dispositif.

La figure 2 est un schéma électrique d'une puce élémentaire 210 d'un dispositif d'affichage dans lequel chaque puce élémentaire correspond à un pixel du dispositif et intègre trois sous-pixels SPᵣ, SP_{g} et SP_{b} adaptés à émettre respectivement de la lumière rouge, de la lumière verte et de la lumière bleue.

Chaque sous-pixel SPᵣ, SP_{g}, SP_{b} de la puce 210 comprend sensiblement les mêmes éléments de circuit que la puce 110 de la figure 1, à savoir une LED 120ᵣ, respectivement 120_{g}, respectivement 120_{b}, un transistor de sélection 131ᵣ, respectivement 131_{g}, respectivement 131_{b}, un transistor de réglage de courant 133ᵣ, respectivement 133_{g}, respectivement 133_{b}, et un élément capacitif 135ᵣ, respectivement 135_{g}, respectivement 135_{b}.

Dans cet exemple, la puce comprend six bornes de connexion à l'extérieur Vp, Vn, Vsel, Vdataᵣ, Vdata_{g} et Vdata_{b}. Les bornes Vp et Vn sont destinées à recevoir respectivement les potentiels d'alimentation bas Vp et haut Vn de la puce. Les bornes Vsel, Vdataᵣ, Vdata_{g} et Vdata_{b} sont destinées à recevoir des signaux de commande de la puce. Plus particulièrement, le signal Vsel est un signal de sélection de la puce, et les signaux Vdataᵣ, Vdata_{g} et Vdata_{b} sont des signaux de réglage individuels des niveaux de luminosité des LED 120ᵣ, 120_{g} et 120_{b} respectivement.

Chacun des transistors 131ᵣ, 131_{g} et 131_{b} a son noeud de commande connecté à la borne Vsel. Le transistor 131ᵣ a un premier noeud de conduction connecté à la borne Vdataᵣ et un deuxième noeud de conduction connecté à un noeud intermédiaire a1ᵣ de la puce, le transistor 131_{g} a un premier noeud de conduction connecté à la borne Vdata_{g} et un deuxième noeud de conduction connecté à un noeud intermédiaire a1_{g} de la puce, et le transistor 131_{b} a un premier noeud de conduction connecté à la borne Vdata_{b} et un deuxième noeud de conduction connecté à un noeud intermédiaire a1_{b} de la puce. L'élément capacitif 135ᵣ a une première électrode connectée au noeud a1ᵣ et une deuxième électrode connectée à la borne Vp, l'élément capacitif 135_{g} a une première électrode connectée au noeud a1_{g} et une deuxième électrode connectée à la borne Vp, et l'élément capacitif 135_{b} a une première électrode connectée au noeud a1_{b} et une deuxième électrode connectée à la borne Vp. Le transistor 133ᵣ a un premier noeud de conduction connecté à la borne Vp, un deuxième noeud de conduction connecté à l'anode de la LED 120ᵣ, et un noeud de commande connecté au noeud a1ᵣ, le transistor 133_{g} a un premier noeud de conduction connecté à la borne Vp, un deuxième noeud de conduction connecté à l'anode de la LED 120_{g}, et un noeud de commande connecté au noeud a1_{g}, et le transistor 133_{b} a un premier noeud de conduction connecté à la borne Vp, un deuxième noeud de conduction connecté à l'anode de la LED 120b, et un noeud de commande connecté au noeud a1_{b}. Chacune des LED 120ᵣ, 120_{g}, 120_{b} a sa cathode connectée à la borne Vn.

Les LED 120ᵣ, 120_{g} et 120_{b} sont par exemple des LED de natures distinctes adaptées à émettre de la lumière dans des gammes de longueurs d'ondes distinctes. A titre de variante, les LED 120ᵣ, 120_{g} et 120_{b} sont de même nature et émettent dans la même gamme de longueurs d'onde, mais sont surmontées de filtres ou d'éléments de conversion photoluminescents de natures distinctes de façon que les pixels SPᵣ, SP_{g} et SP_{b} émettent dans des gammes de longueurs d'onde distinctes.

Le fonctionnement de la puce élémentaire 210 est par exemple similaire à ce qui a été décrit en relation avec la figure 1, à la différence près que, dans l'exemple de la figure 2, lors de la sélection de la puce élémentaire 210 par application d'un signal de commande adapté sur la borne Vsel, les potentiels des noeuds a1ᵣ, a1_{g} et a1_{b} sont simultanément mis à jour en fonction des potentiels appliqués sur les bornes Vdataᵣ, Vdata_{g} et Vdata_{b} respectivement, ce qui conduit à mettre à jour simultanément les réglages de luminosité individuels des LED 120ᵣ, 120_{g} et 120_{b}.

Un inconvénient du dispositif d'affichage de la figure 2 est que le nombre d'éléments de connexion électrique à prévoir sur le substrat de report pour permettre de commander individuellement chaque pixel du dispositif reste relativement élevé, notamment en raison du fait que les signaux de réglage de luminosité Vdataᵣ, Vdata_{g} et Vdata_{b} sont portés par des pistes conductrices distinctes du substrat de report.

Selon un aspect d'un mode de réalisation, on prévoit de réaliser un dispositif d'affichage dans lequel chaque puce élémentaire intègre plusieurs sous-pixels commandables individuellement, mais dans lequel, dans chaque puce élémentaire, une unique borne de connexion à l'extérieur est prévue pour recevoir les signaux de réglage de luminosité individuels des différents sous-pixels de la puce, les signaux de réglage de luminosités individuels des sous-pixels étant multiplexés temporellement sur cette borne de connexion.

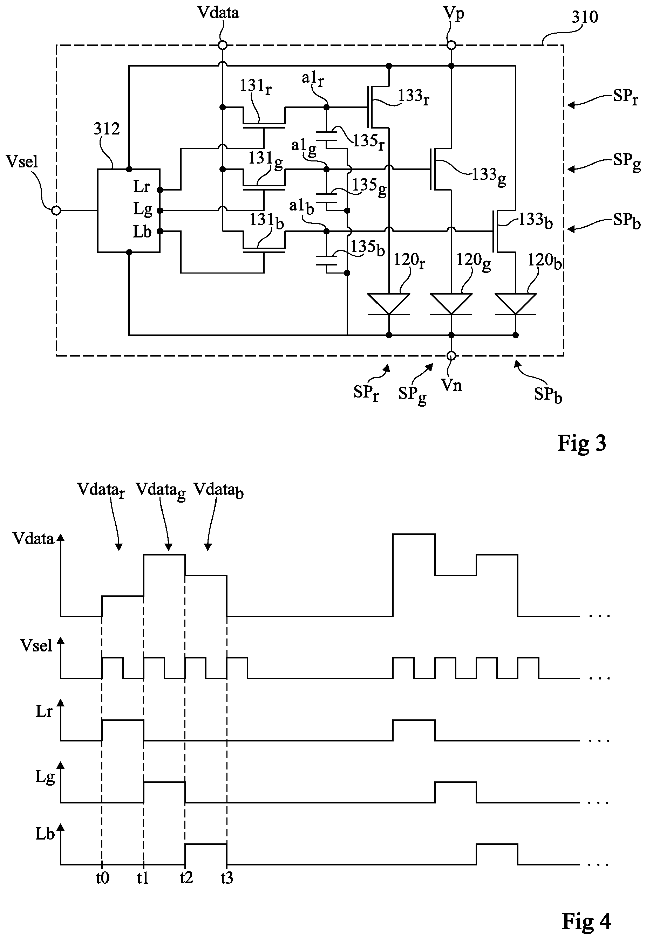

La figure 3 est un schéma électrique simplifié des circuits d'une puce élémentaire 310 d'un exemple d'un dispositif d'affichage d'images selon un mode de réalisation.

Comme dans l'exemple de la figure 2, chaque puce élémentaire 310 correspond à un pixel du dispositif et intègre trois sous-pixels SPᵣ, SP_{g} et SP_{b} adaptés à émettre respectivement de la lumière rouge, de la lumière verte et de la lumière bleue.

Chaque sous-pixel SPᵣ, SP_{g}, SP_{b} de la puce 310 comprend sensiblement les mêmes éléments de circuit que dans l'exemple de la figure 2, à savoir une LED 120ᵣ, respectivement 120_{g}, respectivement 120_{b}, un transistor de sélection 131ᵣ, respectivement 131_{g}, respectivement 131_{b}, un transistor de réglage de courant 133ᵣ, respectivement 133_{g}, respectivement 133_{b}, et un élément capacitif 135ᵣ, respectivement 135_{g}, respectivement 135_{b}. Dans l'exemple représenté, les transistors 131ᵣ, 131_{g}, 131_{b}, 133ᵣ, 133_{g}, 133_{b} sont des transistors MOS à canal N.

Dans cet exemple, la puce comprend quatre bornes de connexion à l'extérieur Vp, Vn, Vsel et Vdata. Les bornes Vp et Vn sont destinées à recevoir respectivement un potentiel d'alimentation bas Vp et un potentiel d'alimentation haut Vn de la puce. Les bornes Vsel et Vdata sont destinées à recevoir des signaux de commande de la puce. Plus particulièrement, la borne Vsel est destinée à recevoir un signal de sélection de la puce, et la borne Vdata est destinée à recevoir des signaux individuels de réglage des niveaux de luminosité des LED 120ᵣ, 120_{g}, 120_{b}, multiplexés temporellement.

La puce 310 comprend en outre un circuit de sélection interne 312 recevant le signal Vsel et fournissant des signaux de sélection Lr, Lg et Lb appliqués respectivement sur les grilles des transistors 131ᵣ, 131_{g} et 131_{b}. Plus particulièrement, dans l'exemple représenté, le circuit 312 comprend trois noeuds de sortie Lr, Lg et Lb connectés respectivement aux grilles de transistors 131ᵣ, 131_{g} et 131_{b}. Le circuit 312 est en outre relié aux bornes Vp et Vn de la puce pour son alimentation.

Le transistor 131ᵣ a un premier noeud de conduction connecté à la borne Vdata et un deuxième noeud de conduction connecté à un noeud intermédiaire a1ᵣ de la puce, le transistor 131_{g} a un premier noeud de conduction connecté à la borne Vdata et un deuxième noeud de conduction connecté à un noeud intermédiaire a1_{g} de la puce, et le transistor 131_{b} a un premier noeud de conduction connecté à la borne Vdata et un deuxième noeud de conduction connecté à un noeud intermédiaire a1_{b} de la puce. L'élément capacitif 135ᵣ a une première électrode connectée au noeud a1ᵣ et une deuxième électrode connectée à la borne Vn, l'élément capacitif 135_{g} a une première électrode connectée au noeud a1_{g} et une deuxième électrode connectée à la borne Vn, et l'élément capacitif 135_{b} a une première électrode connectée au noeud a1_{b} et une deuxième électrode connectée à la borne Vn. Le transistor 133ᵣ a un premier noeud de conduction connecté à la borne Vp, un deuxième noeud de conduction connecté à l'anode de la LED 120ᵣ, et un noeud de commande connecté au noeud a1ᵣ, le transistor 133_{g} a un premier noeud de conduction connecté à la borne Vp, un deuxième noeud de conduction connecté à l'anode de la LED 120_{g}, et un noeud de commande connecté au noeud a1_{g}, et le transistor 133_{b} a un premier noeud de conduction connecté à la borne Vp, un deuxième noeud de conduction connecté à l'anode de la LED 120b, et un noeud de commande connecté au noeud a1_{b}. Chacune des LED 120ᵣ, 120_{g}, 120_{b} a sa cathode connectée à la borne Vn.

La figure 4 est un chronogramme illustrant un exemple d'un mode de fonctionnement de la puce élémentaire 310 de la figure 3. Plus particulièrement, la figure 4 représente l'évolution, en fonction du temps, des signaux Vdata, Vsel, Lr, Lg et Lb de la puce 310 lors d'une phase de mise à jour des niveaux de luminosité individuels des sous-pixels SPᵣ, SP_{g} et SP_{b} de la puce.

Pour commander la mise à jour des niveaux de luminosité individuels des sous-pixels SPᵣ, SP_{g} et SP_{b} de la puce, un train d'impulsions est appliqué sur la borne Vsel de la puce. Plus particulièrement, dans cet exemple, le train d'impulsions comprend nbSP+1 impulsions, par exemple régulièrement espacées dans le temps, où nbSP est le nombre de sous-pixels de la puce (nbSP=3 dans cet exemple) . Le front montant de la première impulsion du train d'impulsions marque le début de la phase de mise à jour du pixel, et le front montant de la dernière impulsion du train d'impulsions marque la fin de la phase de mise à jour du pixel.

A un instant t0 de début de la phase de mise à jour du pixel, correspondant au front montant de la première impulsion du signal Vsel, le circuit de sélection interne 312 commande la fermeture du transistor de sélection 131ᵣ du sous-pixel SPᵣ, et le maintien à l'état ouvert des transistors de sélection 131_{g} et 131_{b} des sous-pixels SP_{g} et SP_{b}. Pour cela, dans cet exemple, à l'instant t0, le signal Lr est mis à un état haut et les signaux Lg et Lb sont mis à un état bas.

Entre l'instant t0 et un instant t1 correspondant au front montant de la deuxième impulsion du signal Vsel, le condensateur 135ᵣ du pixel SPᵣ se charge à un niveau de tension fonction du potentiel appliqué sur la borne Vdata entre les instants t0 et t1, tandis que les niveaux de tension des condensateurs 135_{g} et 135_{b} restent sensiblement inchangés.

A l'instant t1, le circuit de sélection interne 312 commande l'ouverture du transistor de sélection 131ᵣ du sous-pixel SPᵣ, la fermeture du transistor de sélection 131_{g} du sous-pixel SP_{g}, et le maintien à l'état ouvert du transistor de sélection 131_{b} du sous-pixel SP_{b}. Pour cela, dans cet exemple, à l'instant t1, le signal Lr est mis à l'état bas, le signal Lg est mis à l'état haut, et le signal Lb est maintenu à l'état bas.

Entre l'instant t1 et un instant t2 correspondant au front montant de la troisième impulsion du signal Vsel, le condensateur 135_{g} du pixel SP_{g} se charge à un niveau de tension fonction du potentiel appliqué sur la borne Vdata entre les instants t1 et t2, tandis que les niveaux de tension des condensateurs 135ᵣ et 135_{b} restent sensiblement inchangés.

A l'instant t2, le circuit de sélection interne 312 commande l'ouverture du transistor de sélection 131_{g} du sous-pixel SP_{g}, la fermeture du transistor de sélection 131_{b} du sous-pixel SPb, et le maintien à l'état ouvert du transistor de sélection 131ᵣ du sous-pixel SPᵣ. Pour cela, dans cet exemple, à l'instant t2, le signal Lg est mis à l'état bas, le signal Lb est mis à l'état haut, et le signal Lr est maintenu à l'état bas.

Entre l'instant t2 et un instant t3 correspondant au front montant de la troisième impulsion du signal Vsel, le condensateur 135_{b} du pixel SP_{b} se charge à un niveau de tension fonction du potentiel appliqué sur la borne Vdata entre les instants t2 et t3, tandis que les niveaux de tension des condensateurs 135ᵣ et 135_{g} restent sensiblement inchangés.

L'instant t3 marque la fin de la phase de mise à jour du pixel. A partir de l'instant t3, les niveaux de luminosités des LED 120ᵣ, 120_{g} et 120_{b} restent sensiblement inchangés jusqu'à la prochaine mise à jour du pixel.

Comme on peut le voir sur la figure 4, dans cet exemple, le niveau du signal Vdata varie entre les instants t0 et t3, par paliers à chaque nouveau front montant du signal Vsel. La portion du signal Vdata entre les instants t0 et t1 correspond à un signal individuel de réglage de la LED 120ᵣ du sous-pixel SPᵣ, la portion du signal Vdata entre les instants t1 et t2 correspond à un signal individuel de réglage de la LED 120_{g} du sous-pixel SP_{g}, et la portion du signal Vdata entre les instants t2 et t3 correspond à un signal individuel de réglage de la LED 120_{g} du sous-pixel SP_{g}. Les signaux de réglage individuels Vdataᵣ, Vdata_{g} et Vdata_{b} sont donc multiplexés temporellement sur la borne Vdata. L'ensemble comprenant le circuit de sélection interne 312, les transistors 131ᵣ, 131_{g}, 131_{b}, 133ᵣ, 133_{g}, 133_{b} et les condensateurs 135ᵣ, 135_{g} et 135_{b} de la puce constitue un circuit de commande adapté à démultiplexer les signaux de réglage individuels reçus sur la borne Vdata, et à appliquer à chaque LED de la puce un signal de polarisation (un courant dans cet exemple) fonction du signal de réglage individuel de la LED.

On notera que la réalisation du circuit de sélection interne 312 de la puce, adapté à mettre en oeuvre le fonctionnement décrit en relation avec la figure 4, n'a pas été détaillé, la réalisation d'un tel circuit étant à la portée de l'homme du métier à partir des indications fonctionnelles de la présente description. A titre d'exemple, le circuit 312 peut comporter un compteur d'impulsions à deux étages associé à des portes de décodage, et à un mécanisme de réinitialisation, par exemple obtenu par un montage de type détecteur d'enveloppe recevant en entrée le signal Vsel.

De façon similaire à ce qui a été décrit en relation avec la figure 1, les puces élémentaires 310 du dispositif d'affichage de la figure 3 peuvent être agencées en matrice selon des lignes et des colonnes, et interconnectés en lignes et en colonnes de façon à permettre une commande simultanée, ligne par ligne, des pixels du dispositif.

Un avantage du mode de réalisation décrit en relation avec la figure 3 est que chaque puce élémentaire 310 comprend une unique borne Vdata pour recevoir les signaux de réglage individuels de l'ensemble des sous-pixels de la puce. Ainsi, dans l'exemple de la figure 3, chaque puce élémentaire 310 comprend seulement quatre bornes de connexion à l'extérieur, c'est-à-dire pas plus que dans une puce élémentaire du type décrit en relation avec la figure 1 (comprenant une unique LED). Ceci permet en particulier, par rapport à l'exemple de la figure 2, de réduire le nombre d'éléments de connexion électrique à prévoir sur le substrat de report. En effet, dans le mode de réalisation de la figure 3, les signaux de réglage individuel de luminosité Vdataᵣ, Vdata_{g} et Vdata_{b} des différents sous-pixels d'une même puce 310 sont portés par une même piste conductrice du substrat de report.

On notera que les modes de réalisation décrits ne se limitent pas à l'exemple particulier décrit en relation avec la figure 3, dans lequel chaque puce élémentaire comprend un unique pixel divisé en trois sous-pixels adaptés à émettre dans trois gammes de longueurs d'ondes distinctes. A titre de variante, chaque puce élémentaire peut comprendre un unique pixel divisé en un nombre de sous-pixels différent de trois. Dans une autre variante, chaque puce élémentaire peut comprendre plusieurs pixels divisés ou non en sous-pixels de couleurs distinctes.

En particulier, comme cela va être expliqué plus en détail ci-après, les modes de réalisation décrits sont particulièrement adaptés à la réalisation d'un dispositif d'affichage dit multi-vues, c'est-à-dire dans lequel l'image à afficher est divisée en macropixels comportant chacun une pluralité de pixels correspondant à des vues différentes de la scène que l'on souhaite reproduire. A titre d'exemple, les différents pixels d'un même macropixel correspondent respectivement à un même pixel de différentes images d'une même scène, prises sous des angles de vue différents. Un dispositif d'affichage multi-vues peut par exemple être utilisé dans des applications dans lesquelles on souhaite donner à l'utilisateur une impression de visualisation en trois dimensions.

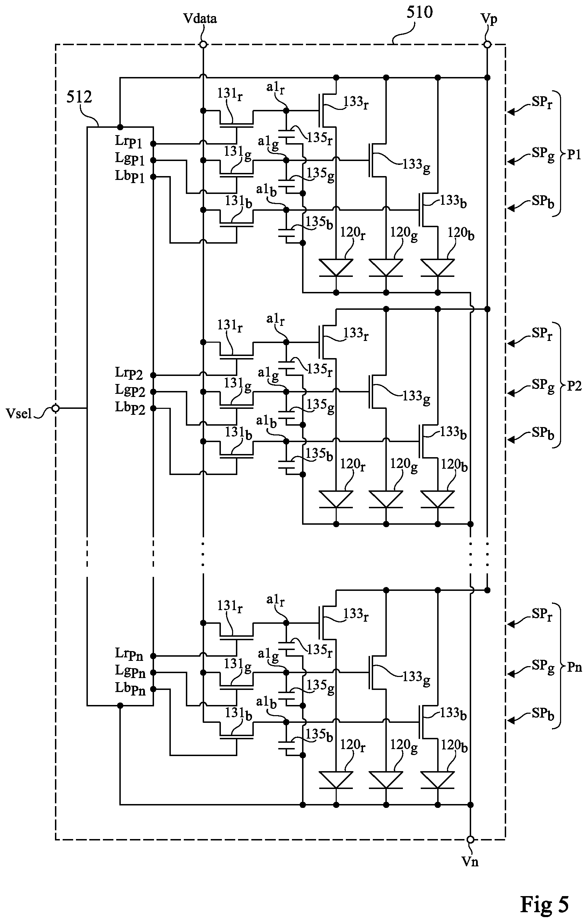

La figure 5 est un schéma électrique simplifié des circuits d'une puce élémentaire 510 d'un exemple d'un dispositif d'affichage d'images multi-vues selon un mode de réalisation.

Dans cet exemple, chaque puce élémentaire 510 correspond à un macropixel du dispositif, comprenant n pixels P1, P2, ... Pn destinés à afficher respectivement un même point de n images différentes, correspondant par exemple à n vues différentes d'une même scène, où n est un entier supérieur à 1, par exemple compris dans la gamme allant de 2 à 50. Dans cet exemple, chaque pixel Pi du macropixel, avec i entier allant de 1 à n, comprend plusieurs sous-pixels adaptés à émettre dans des gammes de longueurs d'ondes distinctes, de façon à permettre l'affichage d'images couleur. Plus particulièrement, dans l'exemple représenté, chaque pixel Pi comprend trois sous-pixels SPᵣ, SP_{g} et SP_{b} adaptés à émettre respectivement de la lumière rouge, de la lumière verte et de la lumière bleue. Comme dans l'exemple de la figure 3, la puce 510 de la figure 5 comprend quatre bornes de connexion à l'extérieur Vp, Vn, Vsel et Vdata. Chaque sous-pixel SPᵣ, SP_{g}, SP_{b} de la puce 510 comprend sensiblement les mêmes éléments de circuit que dans l'exemple de la figure 3, agencés sensiblement de la même manière. Dans l'exemple de la figure 5, les transistors de sélection 131ᵣ, 131_{g}, 131_{b} de tous les pixels P1, P2, ... Pn de la puce 510 (soit n*3 transistors de sélection) ont leur premier noeud de conduction connecté à la même borne Vdata de la puce.

La puce 510 comprend en outre un circuit de sélection interne 512 similaire au circuit 312 de la figure 3, recevant le signal Vsel et fournissant, pour chaque pixel Pi, des signaux de sélection Lr_{Pi}, Lg_{Pi} et Lb_{Pi} appliqués respectivement sur les grilles des transistors 131ᵣ, 131_{g} et 131_{b} du pixel Pi. Autrement dit, le circuit 512 comprend n*3 noeuds de sortie Lr_{P1}, Lg_{P1}, Lb_{P1}, Lr_{P2}, Lg_{P2}, Lb_{P2}, ... Lr_{Pn}, Lg_{Pn}, Lb_{Pn} connectés respectivement aux grilles des transistors de sélection 131ᵣ, 131_{g} et 131_{b} des n pixels Pi de la puce. Le circuit 512 est en outre relié aux bornes Vp et Vn de la puce pour son alimentation.

Le fonctionnement de la puce élémentaire 510 de la figure 5 est similaire à ce qui a été décrit ci-dessus en relation avec les figures 3 et 4. Plus particulièrement, dans l'exemple de la figure 5, lors d'une phase de mise à jour des n*3 sous-pixels de la puce, les n*3 signaux individuels de réglages des n*3 LED de la puce sont multiplexés temporellement sur la borne Vdata de la puce. Le signal de sélection Vsel comprend par exemple un train de (n*3)+1 impulsions pour synchroniser le démultiplexage du signal Vdata à l'intérieur de la puce.

De façon similaire à ce qui a été décrit précédemment, les puces élémentaires 510 du dispositif d'affichage de la figure 5 peuvent être agencées en matrice selon des lignes et des colonnes, et interconnectés en lignes et en colonnes de façon à permettre une commande simultanée, ligne par ligne, des macropixels du dispositif.

On notera que lorsque le nombre de LED à commander individuellement dans chaque puce élémentaire du dispositif est important, il peut être avantageux de transmettre les signaux de réglage individuel des différentes LED de la puce sous la forme de données numériques sérialisées sur la borne de connexion Vdata de la puce, notamment afin de pouvoir réaliser un transfert plus rapide des signaux de réglage.

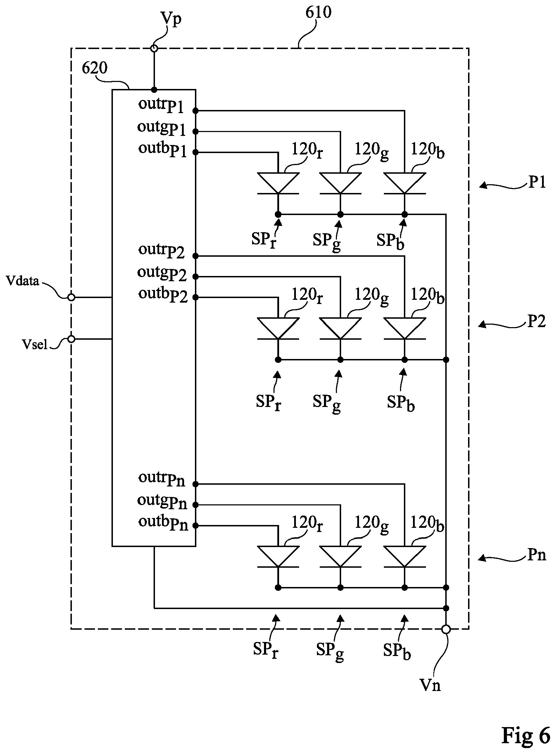

La figure 6 est un schéma électrique simplifié des circuits d'une puce élémentaire 610 d'un exemple d'un dispositif d'affichage d'images multi-vues selon un mode de réalisation. La puce 610 de la figure 6 diffère de la puce 510 de la figure 5 principalement en ce que, dans la puce 610, les signaux de réglage individuel des différentes LED de la puce sont reçus sous la forme de données numériques sérialisées sur la borne de connexion Vdata de la puce.

Comme dans l'exemple de la figure 5, la puce élémentaire 610 de la figure 6 correspond à un macropixel du dispositif d'affichage, comprenant n pixels P1, P2, ... Pn comprenant chacun trois sous-pixels SPᵣ, SP_{g} et SP_{b} comprenant chacun une LED réglable individuellement. Dans cet exemple, chaque sous-pixel SPᵣ comprend une LED 120ᵣ agencée pour émettre de la lumière rouge, chaque sous-pixel SP_{g} comprend une LED 120_{g} agencée pour émettre de la lumière verte, et chaque sous-pixel SP_{b} comprend une LED 120_{b} agencée pour émettre de la lumière bleue. Dans cet exemple, toutes les LED de la puce ont leur région de cathode connectée à la borne d'alimentation basse Vn de la puce.

Dans l'exemple de la figure 6, la puce 610 comprend en outre un circuit de commande 620 connecté aux bornes de connexion à l'extérieur Vsel, Vdata, Vp et Vn de la puce. Le circuit 620 est adapté à décoder le signal numérique sérialisé reçu par la puce sur sa borne Vdata, et à appliquer à chaque LED de la puce un signal de polarisation fonction du signal de réglage individuel de la LED reçu sous forme numérique sur la borne Vdata. Pour cela, le circuit 620 comprend n*3 noeuds de sortie ou noeuds de fourniture de signaux de polarisation, reliés respectivement aux régions de contact d'anode des n*3 LED de la puce. Plus particulièrement, le circuit 620 comprend, pour chaque pixel Pi de la puce, un noeud de sortie outr_{Pi} relié à l'anode de la LED 120ᵣ du pixel Pi, un noeud de sortie outg_{Pi} relié à l'anode de la LED 120_{g} du pixel Pi, et un noeud de sortie outb_{Pi} relié à l'anode de la LED 120_{b} du pixel Pi. Le circuit 620 est par exemple adapté à fournir à chaque LED de la puce, via son noeud de sortie connecté à l'anode de la LED, un courant de polarisation fonction du signal de réglage individuel de la LED reçu sur la borne Vdata de la puce. Dans l'exemple de la figure 6, le circuit de commande 620 vient en remplacement du circuit de commande formé par le circuit de sélection interne 512, les transistors 131ᵣ, 131_{g}, 131_{b}, 133ᵣ, 133_{g}, 133_{b} et les condensateurs 135ᵣ, 135_{g} et 135_{b} dans l'exemple de la figure 5.

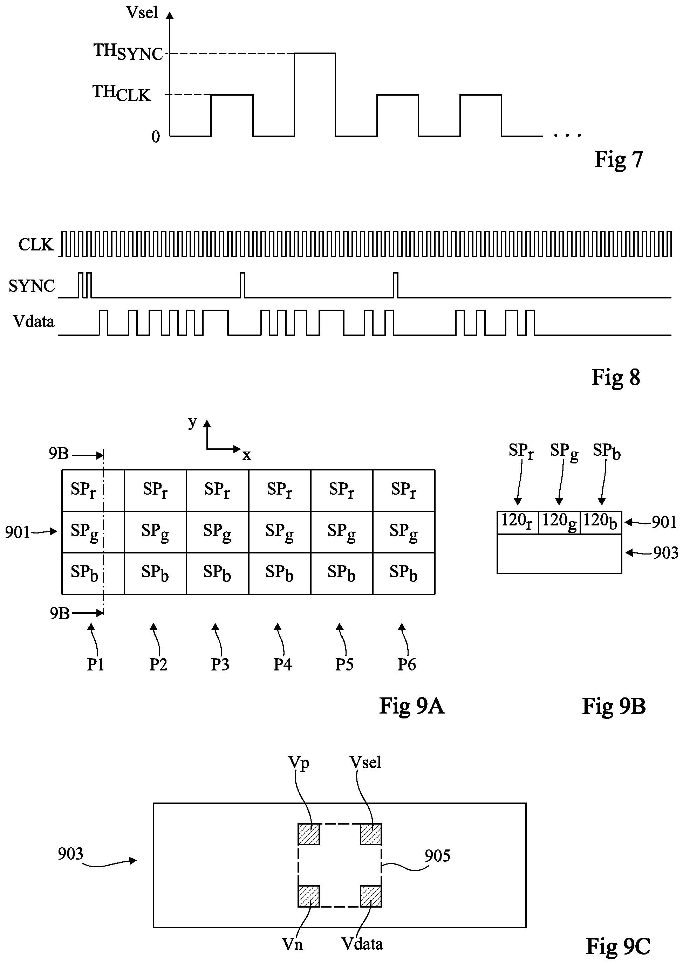

Les figures 7 et 8 sont des chronogrammes illustrant un exemple d'un mode de fonctionnement de la puce élémentaire 610 de la figure 6. Plus particulièrement, la figure 7 représente de façon partielle le signal appliqué sur la borne Vsel de la puce lors d'une phase de mise à jour des niveaux de luminosité individuels des sous-pixels de la puce. La figure 8 représente l'évolution de signaux CLK et SYNC internes à la puce générés par le circuit 620 à partir du signal Vsel. La figure 8 représente en outre l'évolution du signal Vdata appliqué à la puce lors d'une phase de mise à jour des niveaux de luminosité individuels des sous-pixels de la puce.

Dans cet exemple, le signal Vsel est un signal à trois niveaux, un niveau bas (0), un niveau intermédiaire TH_{CLK} supérieur au niveau bas, et un niveau haut TH_{SYNC} supérieur au niveau intermédiaire. Le signal Vsel transmis à la puce 610 lors d'une phase de mise à jour des niveaux de luminosité individuels des sous-pixels de la puce correspond à la superposition d'un signal d'horloge périodique CLK, correspondant à une succession d'impulsions régulièrement espacées de niveau intermédiaire TH_{CLK}, et d'un signal de synchronisation SYNC, correspondant à une succession d'impulsions de niveau haut TH_{SYNC}.

Le circuit de commande 620 comprend un étage (non détaillé) de séparation des signaux CLK et SYNC, recevant sur un noeud d'entrée le signal Vsel et fournissant sur deux noeuds de sortie distincts deux signaux binaires correspondant respectivement au signal CLK et au signal SYNC. A titre d'exemple, la séparation des signaux CLK et SYNC est réalisée au moyen de deux comparateurs comparant le signal Vsel respectivement au seuil TH_{CLK} et au seuil TH_{SYNC}, les sorties des comparateurs fournissant respectivement le signal CLK et le signal SYNC.

Le signal CLK est un signal d'horloge permettant de cadencer les opérations de décodage du signal numérique sérialisé transmis sur la borne Vdata, et le signal SYNC est un signal de synchronisation permettant d'indiquer au circuit de commande 620 qu'il va recevoir des données à décoder sur la borne Vdata de la puce.

Dans l'exemple de la figure 8, on considère une puce 610 correspondant à un macropixel de n=5 pixels comprenant chacun nbSP = 3 sous-pixels, soit 15 LED à mettre à jour. De plus, on considère dans cet exemple que le signal de réglage individuel de chaque LED de la puce 610 est codé sur nbits = 4 bits. En pratique, le nombre nbits de bits sur lequel est codé chaque signal de réglage individuel de LED peut être différent de 4, par exemple compris dans la plage allant de 4 à 16 bits.

Dans cet exemple, la séquence de mise à jour du macropixel commence avec l'application d'une double impulsion du signal SYNC sur la borne Vsel.

A réception de cette double impulsion du signal SYNC, le circuit 620 est informé que des données binaires sérialisées de mise à jour du macropixel vont être transmises sur sa borne Vdata. Un compteur interne au circuit 620, cadencé par le signal d'horloge CLK, est par exemple réinitialisé à cette étape.

Après la double impulsion du signal SYNC, un train de n*nbits = 5*4 = 20 bits de données est transmis au circuit 620 via la borne Vdata, correspondant aux signaux individuels de réglage des n sous-pixels d'une première couleur du macropixel, par exemple les n sous-pixels SPᵣ du macropixel.

Une impulsion simple du signal SYNC est ensuite appliquée sur la borne Vsel. Le circuit 620 est ainsi informé qu'un deuxième train de n*nbits de données va lui être transmis via la borne Vdata, correspondant aux signaux individuels de réglage des n sous-pixels d'une deuxième couleur du macropixel, par exemple les n sous-pixels SP_{g} du macropixel.

Après la transmission du deuxième train de n*nbits, une nouvelle impulsion simple du signal SYNC est appliquée sur la borne Vsel, de façon à informer le circuit 620 qu'un troisième train de n*nbits de données va lui être transmis via la borne Vdata, correspondant aux signaux individuels de réglage des n sous-pixels d'une troisième couleur du macropixel, par exemple les n sous-pixels SP_{b} du macropixel.

On notera que l'ordre dans lequel les données sont transmises au circuit 620 n'a pas d'importance pourvu que le circuit 620 ait connaissance de cet ordre et soit adapté.

En outre, bien que l'on ait représenté un exemple de mise en oeuvre dans lequel les transmissions des signaux de réglage des différentes couleurs du macropixel sont séparées par des impulsions du signal SYNC, les modes de réalisation décrits ne se limitent pas à ce cas particulier. A titre de variante, le signal SYNC peut comporter une unique impulsion simple au début de la phase de mise à jour, les données étant ensuite transmises sous la forme d'un train ininterrompu de n*nbSP*nbits bits, soit 60 bits dans l'exemple considéré.

Pour chaque signal individuel de réglage d'une LED du macropixel, une conversion numérique-analogique du signal de réglage individuel reçu sur la borne Vdata peut être mise en oeuvre. Un signal de polarisation (courant ou tension) fonction du signal de réglage reçu est ensuite appliqué à la LED. A titre d'exemple, pour chaque LED de la puce 610, le circuit 620 comprend un convertisseur numérique-analogique, soit n*nbSP convertisseurs numérique-analogique au total. Le signal analogique de sortie du convertisseur numérique-analogique associé à une LED est par exemple directement appliqué sur l'anode de la LED. A titre de variante, le signal de sortie du convertisseur numérique-analogique est utilisé pour régler une source de courant commandable injectant un courant dans la LED.

De façon similaire à ce qui a été décrit précédemment, les puces élémentaires 610 du dispositif d'affichage de la figure 6 peuvent être agencées en matrice selon des lignes et des colonnes, et interconnectés en lignes et en colonnes de façon à permettre une commande simultanée, ligne par ligne, des macropixels du dispositif.

On notera que les exemples des figures 5 et 6 peuvent être adaptés au cas où les pixels P1, P2, ... Pn de chaque puce élémentaire 510 ou 610 du dispositif sont des pixels monochromatiques du type décrit en relation avec la figure 1, c'est-à-dire non divisés en sous-pixels adaptés à émettre dans des gammes de longueurs d'ondes distinctes.

De plus, la variante de la figure 6 (transmission numérique des signaux de réglage) peut être adaptée au cas où la puce élémentaire 610 comprend, comme dans l'exemple de la figure 3, un unique pixel divisé en plusieurs sous-pixels adaptés à émettre dans des gammes de longueurs d'onde distinctes.

Les figures 9A, 9B et 9C sont des vues schématiques d'une puce élémentaire d'un dispositif d'affichage d'images du type décrit ci-dessus. Dans cet exemple, la puce comprend 6 pixels P1, P2, P3, P4, P5 et P6 comprenant chacun trois sous-pixels SPᵣ, SP_{g} et SP_{b} adaptés à émettre dans trois gammes de longueurs d'ondes distinctes.

La figure 9A est une vue de dessus de la puce, la figure 9B est une vue en coupe de la puce selon le plan 9B-9B de la figure 9A, et la figure 9C est une vue de dessous de la puce.

Comme cela apparaît sur la figure 9B, la puce comprend un premier substrat 901, par exemple à base de semiconducteur III-V, dans lequel sont formées les LED 120ᵣ, 120_{g}, 120_{b} de la puce, et, accolé et connecté électriquement au substrat 901, un deuxième substrat 903, par exemple en silicium, dans lequel est formé le circuit de commande de la puce.

Comme représenté sur la figure 9C, la puce comprend, du côté de la face du substrat 903 opposée au substrat 901, une zone de connexion électrique 905 comprenant les quatre bornes de connexion à l'extérieur Vp, Vn, Vsel et Vdata de la puce.

On notera que dans l'exemple représenté, comme cela apparaît sur la figure 9A, les pixels P1, P2, ... Pn de la puce sont disposés en barrette, alignés selon un axe x. Les puces élémentaires sont montées sur le substrat de report du dispositif selon un agencement matriciel en lignes et en colonnes, de façon que l'axe x de chaque puce soit sensiblement parallèle aux lignes de la matrice. En effet, dans un dispositif d'affichage multi-vues, on cherche généralement à ce que l'utilisateur puisse percevoir des vues différentes de la scène lorsque l'oeil de l'observateur se déplace selon une direction parallèle à l'axe des lignes de la matrice (généralement une direction horizontale), et non lorsqu'il se déplace selon une direction parallèle à l'axe des colonnes (généralement une direction verticale). En pratique, chaque macropixel est surmonté d'une ou plusieurs lentilles non représentées, adaptées à réaliser la séparation angulaire, selon l'axe x, des faisceaux correspondant aux différents pixels du macropixel.

Dans l'exemple représenté, dans chaque pixel Pi, les sous-pixels SPᵣ, SP_{g}, SP_{b} du pixel sont disposés en barrette, alignés selon un axe y sensiblement orthogonal à l'axe x, et sensiblement parallèle aux colonnes de la matrice de macropixels. Un avantage de cette configuration est qu'elle permet d'éviter une séparation angulaire des différentes couleurs d'un même pixel, du fait de la présence de la ou des lentilles de séparation angulaire selon l'axe x au-dessus du macropixel.

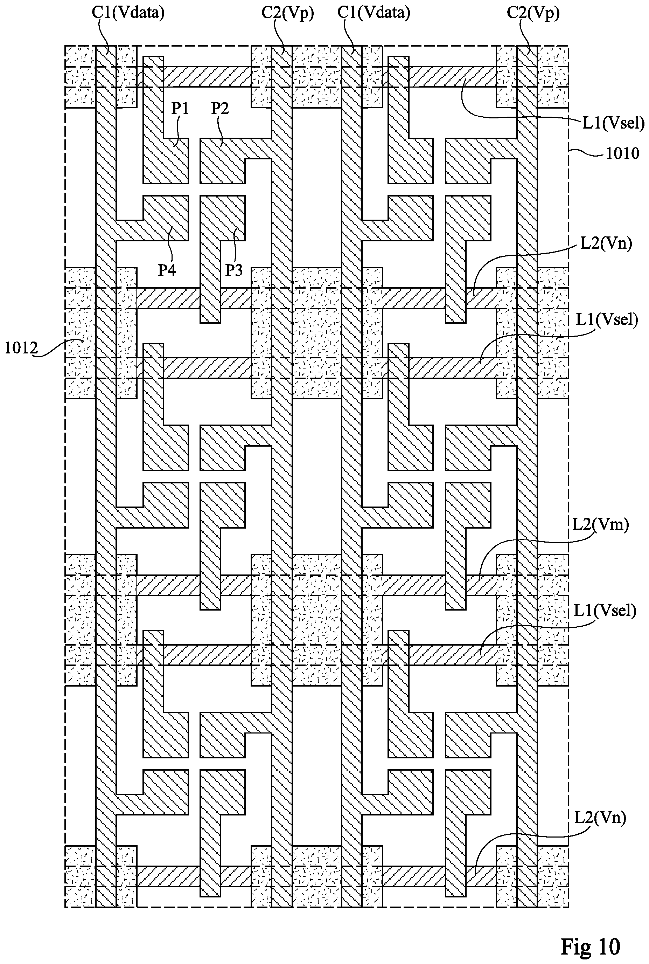

La figure 10 est une vue de dessus schématique et partielle d'un exemple d'un substrat de report pour les puces élémentaires d'un dispositif d'affichage du type décrit ci-dessus en relation avec les figures 3 à 8. Sur la figure 10, seule une portion du substrat de report, correspondant à une sous-matrice de trois lignes par deux colonnes du dispositif d'affichage, a été représentée.

Le substrat de report comprend par exemple une plaque ou feuille de support 1010 en un matériau isolant, par exemple en verre ou en plastique. Le substrat de report comprend en outre des éléments de connexion électrique, et en particulier des pistes conductrices et des plages conductrices, formés par impression sur la face supérieure de la plaque de support 1010. Ces éléments de connexion électrique sont formés par impression d'une succession de niveaux conducteurs et isolants sur la face supérieure de la plaque de support 1010. Les éléments de connexion électrique sont par exemple formés par un procédé d'impression de type impression jet d'encre, par sérigraphie, par rotogravure, ou par toute autre méthode adaptée.

Le substrat de report de la figure 10 est un substrat passif, c'est-à-dire qu'il comprend uniquement des éléments de connexion électrique. Des circuits actifs de commande du dispositif d'affichage, adaptés à alimenter et commander les puces élémentaires du dispositif par l'intermédiaire des éléments de connexion électrique du substrat de report, sont par exemple connectés aux éléments de connexion électrique du substrat de report à la périphérie du substrat de report.

Dans l'exemple représenté, la fabrication du substrat de report comprend les trois étapes successives d'impression suivantes.

Lors d'une première étape d'impression, on imprime sur la face supérieure de la plaque de support 1010 une pluralité de pistes conductrices sensiblement parallèles à la direction des lignes du dispositif d'affichage. Plus particulièrement, dans cet exemple, lors de la première étape d'impression, on imprime, pour chaque ligne du dispositif d'affichage, deux pistes conductrices L1 et L2 s'étendant sur sensiblement toute la longueur des lignes du dispositif d'affichage. Les pistes L1 sont destinées à véhiculer les signaux de commande Vsel des différentes lignes de pixels ou de macropixels du dispositif. Les pistes L2 sont destinées à distribuer le potentiel d'alimentation bas Vn du dispositif. Les éléments conducteurs imprimés lors de cette première étape d'impression définissent un premier niveau conducteur M1 du substrat de report.

Lors d'une deuxième étape d'impression, on recouvre certaines portions des pistes conductrices L1 et L2 d'un matériau isolant 1012, de façon à permettre l'impression ultérieure de pistes conductrices s'étendant au-dessus des pistes L1 et L2, sans créer de court-circuit avec les pistes L1 et L2.

Lors d'une troisième étape d'impression, on imprime sur la face supérieure de la plaque de support 1010 une pluralité de pistes conductrices sensiblement parallèles à la direction des colonnes du dispositif d'affichage. Plus particulièrement, dans cet exemple, lors de la troisième étape d'impression, on imprime, pour chaque colonne du dispositif d'affichage, deux pistes conductrices C1 et C2 s'étendant sur sensiblement toute la longueur des colonnes du dispositif d'affichage. Les pistes C1 sont destinées à véhiculer les signaux de commande Vdata des différentes colonnes de pixels ou de macropixels du dispositif. Les pistes C2 sont destinées à distribuer le potentiel d'alimentation haut Vp du dispositif. Les pistes conductrices C1 et C2 sont isolées des pistes conductrices L1 et L2 par les régions isolantes 1012 formées à l'étape précédente. Lors de la troisième étape d'impression, sont en outre imprimées, pour chaque pixel ou macropixel du dispositif, quatre plages conductrices P1, P2, P3 et P4 destinées à recevoir respectivement les bornes de connexion Vsel, Vp, Vn et Vdata de la puce comprenant le pixel ou le macropixel. La plage P1 est connectée à la piste conductrice L1 associée à la ligne à laquelle appartient le pixel ou le macropixel. Pour cela, la plage P1 s'étend sur et en contact avec la face supérieure de la piste L1 dans une zone de la piste L1 non revêtue par le matériau isolant 1012. La plage P2 est connectée à la piste conductrice C2 associée à la colonne à laquelle appartient le pixel ou le macropixel. Pour cela, la plage P2 est contiguë à la piste conductrice C2. La plage P3 est connectée à la piste conductrice L2 associée à la ligne à laquelle appartient le pixel ou le macropixel. Pour cela, la plage P3 s'étend sur et en contact avec la face supérieure de la piste L2, dans une zone de la piste L2 non revêtue par le matériau isolant 1012. La plage P4 est connectée à la piste conductrice C1 associée à la colonne à laquelle appartient le pixel ou le macropixel. Pour cela, la plage P4 est contiguë à la piste conductrice C1. Les pistes et plages conductrices imprimées lors de la troisième étape définissent un deuxième niveau conducteur M2 du substrat de report. Lors de la troisième étape d'impression, des motifs d'alignement pour le report des puces peuvent en outre être imprimés dans le deuxième niveau conducteur M2.

Un avantage du substrat de report décrit en relation avec la figure 10 est que toutes les plages conductrices de connexion du substrat de report aux puces élémentaires du dispositif d'affichage (les plages P1, P2, P3 et P4) sont formées dans un même niveau conducteur, lors d'une même étape d'impression. Il en résulte que les plages P1, P2, P3 et P4 associées à un même pixel ou macropixel du dispositif peuvent être formées très proches les unes des autres, par exemple distantes deux à deux de moins de 20 µm, de préférence distantes deux à deux de moins de 10 µm, de préférence distantes deux à deux de moins de 5 µm, ce qui serait difficile voire impossible à obtenir si les plages conductrices P1 et P3 étaient formées lors de la première étape d'impression, et les plages conductrices P2 et P4 lors de la troisième étape d'impression. En effet, la résolution d'impression des motifs conducteurs lors d'une même étape d'impression est relativement élevée, tandis qu'il peut exister une erreur d'alignement relativement importante entre des motifs conducteurs formés lors d'étapes d'impression différentes.

Ainsi, le mode de réalisation de la figure 10 permet de maximiser la surface conductrice occupée par les plages P1, P2, P3, P4 dans les zones de connexion du substrat aux puces élémentaires, ce qui permet de faciliter l'étape ultérieure de montage des puces élémentaires sur le substrat de report, en relâchant notamment les contraintes d'alignement des puces par rapport au substrat de report.

On notera que le substrat de report décrit en relation avec la figure 10 peut être utilisé non seulement dans un dispositif d'affichage du type décrit en relation avec les figures 3 à 8, dans lequel chaque puce élémentaire du dispositif comprend plusieurs LED réglables individuellement, mais aussi dans un dispositif d'affichage du type décrit en relation avec la figure 1 dans lequel chaque puce élémentaire du dispositif comprend une unique LED.

En outre, bien que l'on ait décrit uniquement des exemples de réalisation dans lesquels chaque puce élémentaire du dispositif d'affichage comprend quatre bornes de connexion à l'extérieur, le substrat de report décrit en relation avec la figure 10 peut être adapté à un dispositif d'affichage dans lequel chaque puce élémentaire comprend un nombre de bornes de connexion à l'extérieur différent de quatre. Ainsi, selon une définition plus générale du mode de réalisation de la figure 10, on prévoit de former des éléments de connexion électrique du substrat de report par impression sur au moins deux niveaux conducteurs successifs, et de former toutes les plages conductrices de connexion du substrat de report aux puces élémentaires du dispositif d'affichage dans le dernier niveau conducteur imprimé, étant entendu que, pour chaque puce élémentaire le nombre de plages conductrices de connexion du substrat de report à la puce est supérieur ou égal à 2, et de préférence supérieur ou égal à 3.

Des modes de réalisation particuliers ont été décrits. Diverses variantes et modifications apparaîtront à l'homme de l'art. En particulier, les modes de réalisation décrits ne se limitent pas aux exemples de matériaux et/ou de dimensions mentionnés à titre d'exemple dans la présente description. L'invention est définie par les revendications suivantes.

## Revendications

1. Dispositif d'affichage émissif comportant :
un substrat de report (1010) comportant des éléments de connexion électrique (L1, L2, C1, C2, P1, P2, P3, P4) ; et
une pluralité de puces semiconductrices (310 ; 510 ; 610) solidarisées au substrat de report et connectées aux éléments de connexion électrique du substrat de report pour leur commande, chaque puce comportant :
- au moins une LED (120 ; 120ᵣ, 120_{g}, 120_{b}) ;
- une pluralité de bornes de connexion (Vdata, Vsel, Vp, Vn) au substrat de report ; et
- un circuit de commande à base de transistors adapté à appliquer à la dite au moins une LED un signal de polarisation en fonction de signaux reçus sur les bornes de connexions de la puce au substrat de report,
dans lequel le substrat de report (1010) comprend une plaque isolante, les éléments de connexion électrique du substrat de report étant formés par impression, sur une face de ladite plaque, d'un premier niveau conducteur, suivi d'un niveau isolant, suivi d'un deuxième niveau conducteur, les éléments de connexion électrique du substrat de report comportant :
une pluralité de premières pistes conductrices (L1, L2) formées dans le premier niveau conducteur ;
une pluralité de deuxièmes pistes conductrices (C1, C2) formées dans le deuxième niveau conducteur ; et
pour chaque puce du dispositif, une pluralité de plages de connexion électrique (P1, P2, P3, P4) connectées respectivement aux bornes de connexion (Vdata, Vsel, Vp, Vn) de la puce, lesdites plages étant toutes formées dans le deuxième niveau conducteur,
et dans lequel, dans chaque puce élémentaire (310 ; 510 ; 610) du dispositif, ladite au moins une LED de la puce est formée dans un premier substrat (901) à base de semiconducteur III-V et présente des contacts électriques d'anode et de cathode du côté d'une première face du premier substrat, et dans lequel le circuit de commande de la puce est formé dans un deuxième substrat (903) à base de silicium et présente des zones de connexion électrique du côté d'une première face du deuxième substrat, la première face du deuxième substrat étant accolée à la première face du premier substrat de façon à mettre directement en contact les contacts d'anode et de cathode de la LED avec les zones de connexion électrique du circuit de commande, les bornes de connexion (Vdata, Vsel, Vp, Vn) de la puce étant formées du côté d'une deuxième face du deuxième substrat (903) opposée à la première face du deuxième substrat (903).

2. Dispositif selon la revendication 1, dans lequel les premières pistes conductrices sont sensiblement parallèles, et dans lequel les deuxièmes pistes conductrices sont sensiblement orthogonales aux premières pistes.

3. Dispositif selon la revendication 1 ou 2, dans lequel chaque puce élémentaire est disposée de façon que la face de son deuxième substrat (903) opposée au premier substrat (901) soit tournée vers le substrat de report (1010) de façon à réaliser des connexions électriques directes entre les bornes de connexion (Vdata, Vsel, Vp, Vn) de la puce et les plages de connexion électrique (P1, P2, P3, P4) du substrat de report.

4. Dispositif selon l'une quelconque des revendications 1 à 3, dans lequel, pour chaque puce du dispositif, le substrat de report (1010) comprend au moins une plage de connexion électrique (P1, P3) connectée à une première piste conductrice (L1, L2) du substrat de report, et au moins une plage de connexion électrique (P2, P4) connectée à une deuxième piste conductrice (C1, C2) du substrat de report.

5. Dispositif selon l'une quelconque des revendications 1 à 4, dans lequel chaque puce élémentaire comprend une première borne (Vdata) de connexion au substrat de report destinée à recevoir un signal de réglage (Vdata ; Vdataᵣ, Vdata_{g}, Vdata_{b}) de ladite au moins une LED de la puce.

6. Dispositif selon la revendication 5, dans lequel chaque puce élémentaire comprend en outre une deuxième borne (Vsel) de connexion au substrat de report destinée à recevoir un signal de sélection et/ou de synchronisation.

7. Dispositif selon la revendication 5 ou 6, dans lequel chaque puce élémentaire comprend en outre des troisième (Vp) et quatrième (Vn) bornes de connexion au substrat de report destinées à recevoir respectivement un potentiel d'alimentation haut et un potentiel d'alimentation bas de la puce.

8. Dispositif selon l'une quelconque des revendications 5 à 7, dans lequel chaque puce élémentaire comprend une pluralité de LED, et dans lequel la première borne de connexion (Vdata) de la puce est destinée à recevoir, pour chaque LED de la puce, un signal de réglage individuel de la LED, les signaux de réglage individuels des différentes LED de la puce étant multiplexés temporellement sur ladite première borne (Vdata).

9. Dispositif selon la revendication 8, dans lequel, dans chaque puce élémentaire, le circuit de commande de la puce est adapté à démultiplexer les signaux reçus sur ladite première borne et à appliquer à chaque LED de la puce un signal de polarisation fonction du signal de réglage individuel de la LED reçu sur ladite première borne (Vdata).

10. Procédé de fabrication d'un dispositif d'affichage selon l'une quelconque des revendications 1 à 9, comprenant les étapes successives suivantes :
a) imprimer sur ladite face de la plaque isolante le premier niveau conducteur de façon à former ladite pluralité de premières pistes conductrices (L1, L2) ;
b) imprimer le niveau isolant sur le premier niveau conducteur ; et
c) imprimer le deuxième niveau conducteur sur le niveau isolant de façon à former ladite pluralité de plages de connexion électrique (P1, P2, P3, P4).

11. Procédé selon la revendication 10, dans lequel les étapes d'impression a), b) et c) sont réalisées par un procédé d'impression jet d'encre, par sérigraphie ou par rotogravure.

## Patentansprüche

1. Emissive Anzeigevorrichtung, die Folgendes aufweist:
ein Transfersubstrat (1010) mit elektrischen Verbindungselementen (L1, L2, C1, C2, P1, P2, P3, P4); und
eine Vielzahl von Halbleiterchips (310; 510; 610), die an dem Transfersubstrat befestigt und mit den elektrischen Verbindungselementen des Transfersubstrats zu ihrer Steuerung verbunden sind, wobei jeder Chip Folgendes umfasst:
- mindestens eine LED (120; 120ᵣ, 120_{g}, 120_{b});
- eine Vielzahl von Anschlüssen (Vdata, Vsel, Vp, Vn) zur Verbindung mit dem Transfersubstrat; und
- eine auf Transistoren basierende Steuerschaltung, die in der Lage ist, an die mindestens eine LED ein Vorspannungssignal in Abhängigkeit von Signalen anzulegen, die an den Anschlüssen der Verbindung des Chips mit dem Transfersubstrat empfangen werden,
wobei das Transfersubstrat (1010) eine isolierende Platte aufweist, wobei die elektrischen Verbindungselemente des Transfersubstrats durch Drucken einer ersten leitenden Ebene, gefolgt von einer isolierenden Ebene, gefolgt von einer zweiten leitenden Ebene, auf eine Oberfläche der Platte gebildet werden, wobei die Elemente der elektrischen Verbindung des Transfersubstrats Folgendes aufweisen:
eine Vielzahl von ersten Leiterbahnen (L1, L2), die in der ersten Leiterebene ausgebildet sind;
eine Vielzahl von zweiten Leiterbahnen (C1, C2), die in der zweiten Leiterebene ausgebildet sind; und
für jeden Chip der Vorrichtung eine Vielzahl von elektrischen Verbindungsbereichen (P1, P2, P3, P4), die jeweils mit den Verbindungsanschlüssen (Vdata, Vsel, Vp, Vn) des Chips verbunden sind, wobei diese Bereiche alle in der zweiten Leiterebene ausgebildet sind,
und wobei in jedem Elementar-Chip (310; 510; 610) der Vorrichtung die mindestens eine LED des Chips in einem ersten Substrat (901) auf der Basis eines III-V-Halbleiters ausgebildet ist und elektrische Anoden- und Kathodenkontakte auf der Seite einer ersten Oberfläche des ersten Substrats aufweist, und wobei die Chipsteuerschaltung in einem zweiten Substrat (903) auf der Basis von Silizium ausgebildet ist und elektrische Verbindungsbereiche auf der Seite einer ersten Oberfläche des zweiten Substrats aufweist, wobei die erste Oberfläche des zweiten Substrats an die erste Oberfläche des ersten Substrats angrenzt, und zwar derart, dass die Anoden- und Kathodenkontakte der LED direkt mit den elektrischen Verbindungsbereichen der Steuerschaltung in Kontakt gebracht werden, wobei die Verbindungsanschlüsse (Vdata, Vsel, Vp, Vn) des Chips auf der Seite einer zweiten Oberfläche des zweiten Substrats (903) gegenüber der ersten Oberfläche des zweiten Substrats (903) ausgebildet sind.

2. Vorrichtung nach Anspruch 1, wobei die ersten Leiterbahnen im Wesentlichen parallel sind und wobei die zweiten Leiterbahnen im Wesentlichen orthogonal zu den ersten Leiterbahnen sind.

3. Vorrichtung nach Anspruch 1 oder 2, wobei jeder Elementar-Chip so angeordnet ist, dass die dem ersten Substrat (901) gegenüberliegende Oberfläche seines zweiten Substrats (903) dem Transfersubstrat (1010) zugewandt ist, um direkte elektrische Verbindungen zwischen den Anschlüssen (Vdata, Vsel, Vp, Vn) des Chips und den elektrischen Anschlussbereichen (P1, P2, P3, P4) des Transfersubstrats zu bilden.

4. Vorrichtung nach einem der Ansprüche 1 bis 3, wobei das Transfersubstrat (1010) für jeden Chip der Vorrichtung mindestens einen elektrischen Verbindungsbereich (P1, P3), der mit einer ersten Leiterbahn (L1, L2) des Transfersubstrats verbunden ist, und mindestens einen elektrischen Verbindungsbereich (P2, P4), der mit einer zweiten Leiterbahn (C1, C2) des Transfersubstrats verbunden ist, aufweist.

5. Vorrichtung nach einem der Ansprüche 1 bis 4, **dadurch gekennzeichnet, dass** jeder Elementar-Chip einen ersten Anschluss (Vdata) zur Verbindung mit dem Übertragungssubstrat aufweist, der dazu bestimmt ist, ein Signal (Vdata; Vdataᵣ, Vdata_{g}, Vdata_{b}) zur Einstellung der mindestens einen LED des Chips zu empfangen.

6. Vorrichtung nach Anspruch 5, wobei jeder Elementar-Chip außerdem einen zweiten Anschluss (Vsel) zur Verbindung mit dem Transfersubstrat aufweist, der dazu bestimmt ist, ein Auswahl- und/oder Synchronisationssignal zu empfangen.

7. Vorrichtung nach Anspruch 5 oder 6, wobei jeder Elementar-Chip außerdem einen dritten (Vp) und einen vierten (Vn) Anschluss zur Verbindung mit dem Transfersubstrat aufweist, die dazu bestimmt sind, ein hohes Stromversorgungspotenzial bzw. ein niedriges Stromversorgungspotenzial des Chips zu empfangen.

8. Vorrichtung nach einem der Ansprüche 5 bis 7, wobei jeder Elementar-Chip eine Vielzahl von LEDs aufweist und wobei der erste Verbindungsanschluss (Vdata) des Chips dazu bestimmt ist, für jede LED des Chips ein individuelles Signal zum Einstellen der LED zu empfangen, wobei die individuellen Signale zum Einstellen der verschiedenen LEDs des Chips an dem ersten Anschluss (Vdata) zeitlich gemultiplext werden.

9. Vorrichtung nach Anspruch 8, wobei in jedem Elementar-Chip die Chip-Steuerschaltung in der Lage ist, die an dem ersten Anschluss empfangenen Signale zu demultiplexen und an jede LED des Chips ein Vorspannungssignal anzulegen, das eine Funktion des an dem ersten Anschluss (Vdata) empfangenen individuellen LED-Einstellsignals ist.

10. Verfahren zur Herstellung der Anzeigevorrichtung nach einem der Ansprüche 1 bis 9, das die folgenden aufeinanderfolgenden Schritte aufweist:
a) Aufdrucken der ersten Leiterebene auf die Oberfläche der Isolierplatte, um die Vielzahl der ersten Leiterbahnen (L1, L2) zu bilden;
b) Drucken der isolierenden Ebene auf die erste Leiterebene; und
c) Bedrucken der isolierenden Ebene mit der zweiten Leiterebene, um die Vielzahl der elektrischen Verbindungsbereiche (P1, P2, P3, P4) zu bilden.

11. Verfahren nach Anspruch 10, wobei die Druckschritte a), b) und c) durch ein Tintenstrahldruck-, Siebdruck- oder Rotationstiefdruckverfahren ausgeführt werden.

## Claims

1. An emissive display device comprising:
a transfer substrate (1010) comprising electric connection elements (L1, L2, C1, C2, P1, P2, P3, P4); and
a plurality of semiconductor chips (310; 510; 610) fastened to the transfer substrate and connected to the elements of electric connection of the transfer substrate for the control thereof, each chip comprising:
- at least one LED (120; 120ᵣ, 120_{g}, 120_{b});
- a plurality of terminals (Vdata, Vsel, Vp, Vn) of connection to the transfer substrate; and
- a control circuit based on transistors capable of applying to said at least one LED a bias signal according to signals received on the terminals of connection of the chip to the transfer substrate,
wherein the transfer substrate (1010) comprises an insulating plate, the electric connection elements of the transfer substrate being formed by printing, on a surface of said plate, of a first conductive level, followed by an insulating level, followed by a second conductive level, the elements of electric connection of the transfer substrate comprising:
a plurality of first conductive tracks (L1, L2) formed in the first conductive level;
a plurality of second conductive tracks (C1, C2) formed in the second conductive level; and
for each chip of the device, a plurality of electric connection areas (P1, P2, P3, P4) respectively connected to the connection terminals (Vdata, Vsel, Vp, Vn) of the chip, said areas being all formed in the second conductive level,
and wherein, in each elementary chip (310; 510; 610) of the device, said at least one LED of the chip is formed in a first substrate (901) based on a III-V semiconductor and has anode and cathode electric contacts on the side of a first surface of the first substrate, and wherein the chip control circuit is formed in a second substrate (903) based on silicon and has electric connection areas on the side of a first surface of the second substrate, the first surface of the second substrate being adjacent to the first surface of the first substrate to directly place in contact the anode and cathode contacts of the LED with the electric connection areas of the control circuit, the connection terminals (Vdata, Vsel, Vp, Vn) of the chip being formed on the side of a second surface of the second substrate (903) opposite to the first surface of the second substrate (903).

2. The device of claim 1, wherein the first conductive tracks are substantially parallel and wherein the second conductive tracks are substantially orthogonal to the first tracks.

3. The device of claim 1 or 2, wherein each elementary chip is arranged so that the surface of its second substrate (903) opposite to the first substrate (901) faces the transfer substrate (1010) to form direct electric connections between the connection terminals (Vdata, Vsel, Vp, Vn) of the chip and the electric connection areas (P1, P2, P3, P4) of the transfer substrate.

4. The device of any of claims 1 to 3, wherein, for each chip of the device, the transfer substrate (1010) comprises at least one electric connection area (P1, P3) connected to a first conductive track (L1, L2) of the transfer substrate, and at least one electric connection area (P2, P4) connected to a second conductive track (C1, C2) of the transfer substrate.

5. The device of any of claims 1 to 4, wherein each elementary chip comprises a first terminal (Vdata) of connection to the transfer substrate intended to receive a signal (Vdata; Vdataᵣ, Vdata_{g}, Vdata_{b}) for setting said at least one LED of the chip.

6. The device of claim 5, wherein each elementary chip further comprises a second terminal (Vsel) of connection to the transfer substrate intended to receive a selection and/or synchronization signal.

7. The device of claim 5 or 6, wherein each elementary chip further comprises third (Vp) and fourth (Vn) terminals of connection to the transfer substrate intended to respectively receive a high power supply potential and a low power supply potential of the chip.

8. The device of any of claims 5 to 7, wherein each elementary chip comprises a plurality of LEDs, and wherein the first connection terminal (Vdata) of the chip is intended to receive, for each LED of the chip, an individual signal for setting the LED, the individual signals for setting the different LEDs of the chip being temporally multiplexed on said first terminal (Vdata).

9. The device of claim 8, wherein in each elementary chip, the chip control circuit is capable of demultiplexing the signals received on said first terminal and of applying to each LED of the chip a bias signal which is a function of the individual LED setting signal received on said first terminal (Vdata).

10. A method of manufacturing the display device of any of claims 1 to 9, comprising the successive steps of:
a) printing on said surface of the insulating plate the first conductive level to form said plurality of first conductive tracks (L1, L2);
b) printing the insulating level on the first conductive level; and
c) printing the second conductive level on the insulating level to form said plurality of electric connection areas (P1, P2, P3, P4) .

11. The method of claim 10, wherein printing steps a), b), and c) are carried out by an inkjet printing, silk-screening or rotogravure method.
